# EUROPÄISCHE PATENTSCHRIFT

(11) **EP 3 826 327 B1**
(45) Veröffentlichungstag und Bekanntmachung des Hinweises auf die Patenterteilung: **13.12.2023**
(21) Anmeldenummer: 20204523.3
(22) Anmeldetag: 29.10.2020
(51) Int. Cl.: H04R 25/00, H01F 38/14, H01F 27/32, H01F 27/40

(54) **HÖRGERÄT**
HEARING AID
APPAREIL AUDITIF

(30) Priorität: 20.11.2019 DE 102019217861
(43) Veröffentlichungstag der Anmeldung: 26.05.2021
(73) Patentinhaber: Sivantos Pte. Ltd., Singapore 539775 (SG)
(72) Erfinder: NIKLES, Peter, 91054 Erlangen (DE)
(74) Vertreter: FDST Patentanwälte

(56) Entgegenhaltungen:
- GB-A- 2 569 536
- US-A- 5 436 803
- US-A1- 2016 241 063
- US-B2- 7 260 234
- Tim Williams: "15.1.2 LF magnetic fields" In: "EMC for Product Designers", 26. September 2016 (2016-09-26), Newnes, Elsevier Science & Technology, XP055761165, ISBN: 978-0-08-101016-7 Seiten 438-439, * das ganze Dokument *
- Anonymous: "101 EMI Shielding Tips and Tricks", archived by Wayback Machine Internet Archive, 5. November 2017 (2017-11-05), Seiten 1-23, XP055793023, Gefunden im Internet: URL:https://web.archive.org/web/2017110521 5145/https://hollandshielding.com/Shieldin g-tips-and-tricks [gefunden am 2021-04-07]

## Beschreibung

Die Erfindung betrifft ein Hörgerät, insbesondere ein ITE-Hörhilfegerät mit den Merkmalen des Oberbegriffs des Anspruchs 1.

Unter "Hörgerät" wird allgemein ein Gerät verstanden, welches zur Aufbereitung und Darbietung von Schall oder eines Schallsignals an eine Person ausgebildet ist. Die vorliegende Erfindung betrifft speziell ein Hörhilfegerät. Hierunter wird ein Hörgerät verstanden, welches der Versorgung einer hörgeschädigten Person mit akustischen Umgebungssignalen dient. Die akustischen Umgebungssignale werden dabei zur Kompensation oder auch Therapie einer jeweiligen Hörschädigung verarbeitet und insbesondere verstärkt. Ein derartiges Hörhilfegerät besteht prinzipiell aus einem oder mehreren Eingangswandlern, aus einer Signalverarbeitungseinrichtung, einer Verstärkungseinrichtung und aus einem Ausgangswandler. Der Eingangswandler ist in der Regel ein Schallempfänger, z.B. ein Mikrofon und/oder ein elektromagnetischer Empfänger, z.B. eine Induktionsspule. Der Ausgangswandler ist in der Regel als elektroakustischer Wandler, z.B. Lautsprecher, oder als elektromechanischer Wandler, z.B. Knochenleitungshörer, realisiert. Er wird auch als Hörer oder Receiver bezeichnet. Der Ausgangswandler erzeugt Ausgangssignale, die zum Gehör des Patienten (hörgeschädigte Person) geleitet werden und beim Patienten eine Hörwahrnehmung erzeugen sollen. Der Verstärker ist in der Regel in die Signalverarbeitungseinrichtung integriert. Die Stromversorgung des Hörgeräts erfolgt durch eine im Gehäuse des Hörgeräts integrierte Batterie. Üblicherweise sind (Hörgeräte-)Komponenten auf einer gedruckten Leiterplatine als Schaltungsträger angeordnet bzw. damit verbunden.

Es gibt unterschiedliche Ausführungsvarianten von Hörgeräten, insbesondere von Hörhilfegeräten. Dies sind insbesondere ITE-Hörgeräte (In-the-Ear), BTE-Hörgeräte (Behind the Ear), RiC-Hörgeräte (Receiver in Canal), CiC-Hörgeräte (Completely in Canal). Letztere gleichen den ITE-Hörgeräten, werden jedoch vollständig im Gehörgang getragen. Bei den ITE-Hörgeräten wird das Gehäuse, das sämtliche funktionale Komponenten einschließlich Mikrofon und Receiver enthält, mindestens teilweise im Gehörgang getragen. Speziell ITE- oder auch CiC-Hörgeräte weisen daher eine sehr kleine Bauform auf.

Hörgeräte, speziell Hörhilfegeräte, weisen häufig eine Antennenanordnung auf, die beispielsweise zur drahtlosen Übertragung von Datensignalen oder akustischen Signalen dient. Die Antennenanordnungen können für unterschiedliche Einsatzzwecke vorgesehen sein. Beispielsweise dient die Antennenanordnung zur drahtlosen Kommunikation mit einem weiteren Gerät, beispielsweise mit einem weiteren Hörhilfegerät im Falle einer binauralen Versorgung. Darüber hinaus kann eine derartige Antennenanordnung auch zur drahtlosen Kommunikation mit einem sonstigen externen Gerät, beispielsweise einem Abspielgerät für Musik und Sprache, ausgebildet sein. Darüber hinaus kann die Antennenanordnung auch für ein drahtloses, insbesondere induktives Laden einer Batterie des Hörhilfegeräts eingesetzt sein. Aufgrund der begrenzten Platzverhältnisse ist im Falle einer Antennenanordnung häufig eine Abschirmung zwischen der Antennenanordnung und weiteren elektrischen Komponenten erforderlich und gewünscht, um eine unerwünschte wechselseitige Störung zu vermeiden.

Aus der EP 2 811 761 A1 ist ein ITE-Hörhilfegerät zu entnehmen, bei dem zwischen einem Hörer und einer Antennenanordnung, die eine Spule aufweist, ein Abschirmschild angeordnet ist, welcher einstückig mit einem Spulenkern ausgebildet ist.

Aus der EP 3 413 587 A1 ist ein weiteres Hörhilfegerät zu entnehmen, bei dem eine Wicklung einer Antennenanordnung unter Zwischenlage einer Folien-Abschirmung an einem Energiespeicher (Batterie) angeordnet ist.

Gemäß der US 7 260 234 B2 ist eine Antennenspule unter Zwischenlage eines Abschirmbleches um einen Hörer gewickelt.

Speziell bei kleinbauenden Hörgeräten ist eine möglichst kompakte Anordnung der Komponenten des Hörgeräts erforderlich. Problematisch kann hierbei die wechselseitige Beeinflussung der Komponenten aufgrund von elektromagnetischen Einflüssen sein. Insbesondere ein elektromagnetischer Ausgangswandler (Hörer) erzeugt eine starke Strahlung. Angestrebt wird allgemein eine möglichst hohe Sensitivität der Antennenanordnung bei gleichzeitig möglichst geringer wechselseitiger Beeinflussung.

Ausgehend hiervon liegt der Erfindung die Aufgabe zugrunde, ein Hörgerät mit einer kompakt bauenden Antennenanordnung mit hoher Sensitivität zu ermöglichen.

Die Aufgabe wird gelöst durch ein Hörgerät mit den Merkmalen des Anspruchs 1. Das Hörgerät weist allgemein ein Gehäuse auf. Dieses weist typischerweise einen sich in einer Richtung verändernden Innenraum aufweist. Im Falle eines ITE-Gehäuses weitet sich der Innenraum typischerweise von einer Trommelfellseite des Gehäuses zu einer abgewandten Seite auf. Unter "Trommelfellseite" wird diejenige Seite des Gehäuses verstanden, mit der das Gehäuse in den Hörkanal eingesteckt wird, sodass diese Seite dem Trommelfell einer Person zugewandt ist.

Das Hörgerät weist zumindest eine im Gehäuse angeordnete elektrische Komponente auf, die sich in einer Längsrichtung erstreckt. Bei dieser handelt es sich allgemein um eine Hörgeräte-Komponente, die also eine Hörgerätefunktionalität aufweist. Bevorzugt handelt es sich um den Hörer. Weiterhin ist im Gehäuse eine Antennenanordnung integriert, welche eine Wicklung aufweist, die an der elektrischen Komponente angeordnet ist. Zwischen der Komponente und der Wicklung ist weiterhin eine magnetische Lage angeordnet aus einem magnetischen, also permeablen Material. Die Wicklung ist spulenartig unter Zwischenlage der Abschirmfolie um die elektrische Komponente gewickelt. Die magnetische Lage weist einen entlang der elektrischen Komponente erstreckenden Teilabschnitt auf. Der Teilabschnitt ist in bevorzugter Ausgestaltung umfangsseitig um die elektrische Komponente herum angeordnet. Weiterhin weist die magnetische Lage zumindest eine und vorzugsweise mehrere sich an diesen Teilabschnitt und damit auch an die elektrische Komponente in Längsrichtung anschließende Laschen auf. Die zumindest eine Lasche und vorzugsweise die mehreren Laschen stehen daher über die elektrische Komponente über. Die zumindest eine überstehende Lasche begrenzt einen Zwischenraum, welcher zumindest durch einen Teilraum des Innenraums des Gehäuses gebildet ist. Der Zwischenraum ist beispielsweise auf der einen Seite durch die zumindest eine Lasche und auf der anderen Seite von einer (gegenüberliegenden) Innenwandung des Gehäuses begrenzt. Bei mehreren Laschen schließen diese den Zwischenraum vorzugsweise zwischen sich ein.

Die magnetische Lage ist insgesamt funktionell nach Art eines Spulenkerns ausgebildet, wodurch die Sensitivität der Antennenanordnung insgesamt positiv beeinflusst ist. Durch die Fortführung der magnetischen Lage über die Komponenten hinaus wird zunächst diese Funktion des Spulenkerns verstärkt. Zudem werden durch die überstehende magnetische Lasche magnetische Feldlinien in und durch diese magnetische Lasche geführt, was zur Folge hat, dass der Zwischenraum weniger von Magnetfeldern belastet ist, als dass diese ohne die zumindest eine Lasche wäre.

Ein besonderer Vorteil dieser Anordnung ist also darin zu sehen, dass durch die sich an den Teilabschnitt und damit an die elektrische Komponente anschließende Lasche ein (zusätzlicher) Zwischenraum ausgebildet ist, welcher infolge der Laschen einen zusätzlichen "abgeschirmten" Teilbereich innerhalb des Gehäuses definiert. Dieser Zwischenraum eignet sich zur Anordnung von weiteren Hörhilfekomponenten.

Insgesamt ist durch die Fortführung der Abschirmung mit Hilfe der Laschen eine bessere Schirmwirkung und damit auch Abschirmung der Antennenanordnung gegenüber störenden Einflüssen erreicht. Bereits hierdurch ist die Sensitivität der Antennenanordnung erhöht. Eine weitere Verbesserung der Sensitivität kann durch eine geeignete Materialwahl der Abschirmfolie und/oder der Geometrie der Lasche erreicht werden.

Der Zwischenraum, insbesondere der zwischen zwei Laschen ausgebildete Zwischenraum weitet sich dabei vorzugsweise in Längsrichtung auf. Ein Abstand zwischen der zumindest einen Lasche und z.B. der gegenüberliegenden Innenwandung des Gehäuses oder auch der Abstand zwischen zwei insbesondere gegenüberliegenden Laschen vergrößert sich daher in Längsrichtung betrachtet. Durch diese Maßnahme wird eine möglichst effiziente Raumausnutzung speziell bei einem ITE-Hörgerät erreicht. Bei einem solchen ITE-Hörgerät weist das Gerät nämlich typischerweise einen an den Gehörgang angepassten ersten Gehäuseabschnitt mit geringer Querschnittsfläche an, an den sich ein zweiter, sich aufweitender Gehäuseabschnitt anschließt, in dem mehrere weitere Hörgerätekomponenten angeordnet sind. In dem ersten Gehäuseabschnitt mit dem geringen Querschnitt ist die mit der Abschirmfolie umgebene elektrische Komponente angeordnet. Durch die sich aufweitenden Laschen wird daher insbesondere der sich vergrö-ßernde Innenraum im zweiten Gehäuseabschnitt effizient abgeschirmt.

In bevorzugter Ausgestaltung liegt die die zumindest eine Lasche und vorzugsweise mehrere, insbesondere alle Laschen zumindest bereichsweise und vorzugsweise flächig an einer Innenwandung des Gehäuses an. Vorzugsweise ist die Lasche / sind die Laschen an dieser Innenwandung beispielsweise durch Kleben befestigt. Je nach Ausgestaltung der Laschen und der Flexibilität der Laschen schmiegen diese sich vorzugsweise flächig an die Kontur der Innenwandung an.

In einer zweckdienlichen Ausgestaltung ist dabei vorgesehen, dass die zumindest eine Lasche oder mehrere / alle Laschen nur teilweise aufweitend verläuft / verlaufen, also in einem Teilbereich zunächst parallel weiterverlaufen und lediglich in einem aufweitenden Teilbereich nach außen aufweitend in Richtung zur Innenwandung des Gehäuses verläuft.

Gemäß einer weiteren bevorzugten Ausgestaltung ist darüber hinaus vorgesehen, dass zwischen der zumindest einen Lasche und dem Gehäuse zusätzlich zum (innenliegenden) Zwischenraum ein (außenliegender) weiterer Raum (Außenraum) gebildet ist, also ein Raum der durch die Lasche gegenüber dem Zwischenraum abgetrennt ist. In diesem Außenraum sind vorzugsweise weitere Hörgeräte-Komponenten, insbesondere solche mit geringem Störpotential wie z.B. Mikrofon, Schalter, Programmierkontakte usw. angeordnet sind.

Vorzugsweise ist die eine Lasche hierzu nach innen abgebogen. Weitere Laschen sind vorzugsweise nach außen und aufweitend gebogen.

Die zumindest eine, vorzugsweise alle Laschen weisen in Längsrichtung vorzugsweise eine Länge auf, welche zumindest 20% vorzugsweise zumindest 50% und insbesondere zumindest 100% der Länge des Teilabschnitts entspricht. Speziell ist die Länge der Laschen derart gewählt, dass sie - in Längsrichtung betrachtet - zumindest einen Großteil, z.B. zumindest 75% oder zumindest 90% der Länge des zweiten Gehäuseteils überdecken, so dass zumindest ein Großteil der Innenwandung des Gehäuses insbesondere des zweiten Gehäuseteils von den Laschen (zumindest in Längsrichtung betrachtet) abgedeckt ist.

Die Laschen selbst schließen sich vorzugsweise biegeflexibel an den Teilabschnitt an. Hierunter wird verstanden, dass im Übergangsbereich zwischen dem Teilabschnitt und den Laschen diese flexibel abgebogen werden können, sodass sie also zur Längsrichtung unterschiedliche Orientierungen einnehmen können. Vorzugsweise sind die Laschen insgesamt (biege)flexibel ausgebildet, sodass die gewünschte Anpassung an die Innenwandung ermöglicht ist.

Je nach Ausführungsvariante und Aufbau der Laschen weisen diese eine größere oder auch eine geringere Flexibilität auf. Im Falle einer geringeren Flexibilität ist in zweckdienlicher Ausgestaltung zwischen dem Teilabschnitt und einer jeweiligen Lasche ein Gelenk nach Art eines Knickgelenks ausgebildet, an dem die Lasche gegenüber dem Teilabschnitt abgeknickt ist. Die jeweilige Lasche ist dabei über dieses Knickgelenk grundsätzlich in unterschiedlichen Winkelorientierungen bezüglich der Längsrichtung orientierbar. Das Knickgelenk selbst ist beispielsweise nach Art eines Filmscharniers ausgebildet, beispielsweise indem im Bereich des Knickgelenks eine Materialverjüngung eingebracht ist.

In einer Weiterbildung hierzu sind über die Länge der Lasche mehrere derartige Knickgelenke ausgebildet, sodass - auch bei steif ausgebildeten Laschen - eine Anpassung der Laschen an einen gewünschten Verlauf, insbesondere eine Anpassung an die Kontur der Innenwandung ermöglicht ist.

In bevorzugter Ausgestaltung weist die magnetische Lage zumindest eine magnetische Folie auf, also eine Folie aus einem permeablen Material. Insbesondere handelt es sich bei der Folie um eine Ferritfolie. Grundsätzlich kann die magnetische Lage auch mehrere beispielsweise streifenförmige Folien aufweisen. Gemäß einer Ausführungsvariante besteht die magnetische Lage aus der zumindest einen magnetischen Folie.

Die Permeabilitätszahl der magnetischen Lage hängt dabei u.a. von der Frequenz (Resonanzfrequenz) ab, auf die die Antennenanordnung zum Senden/Empfangen von (Daten-)Signalen abgestimmt ist. Speziell ist die Antennenanordnung im vorliegenden Fall zur Datenübertragung bei Frequenzen im Megahertz-Bereich ausgebildet, speziell im Bereich zwischen 1 bis 20 MHz, insbesondere im Bereich von 3 MHz. Grundsätzlich kann die Antennenanordnung aber auch zum Senden/Empfangen im zwei- oder dreistelligen Megahertz-Bereich (beispielsweise bis 300 MHz) ausgebildet sein. Für andere Anwendungen ist die Antennenanordnung auf eine Resonanzfrequenz im Gigahertz-Bereich abgestimmt.

In alternativen Varianten wird die Antennenanordnung für andere Anwendungszwecke beispielsweise für ein induktives Laden, typischerweise bei Frequenzen im kHz-Bereich oder auch als Telecoil-Antennen für Frequenzen bis hinunter in den Herz-Bereich.

Die magnetische Lage weist vorzugsweise - insbesondere bei einer auf den Megahertz-Bereich, speziell auf den Bereich zwischen 1 und 20 MHz abgestimmten Antennenanordnung - eine Permeabilitätszahl im Bereich zwischen 40 und 700, vorzugsweise im Bereich zwischen 100 und 300 auf. Mit zunehmenden Frequenzen, für die die Antennenanordnung ausgebildet ist, werden kleinere Permeabilitätszahlen für die magnetische Folie gewählt. Die Permeabilitätszahl liegt dabei zumindest jedoch >1, sodass das verwendete magnetisch permeable Material zumindest paramagnetisch ist. Vorzugsweise liegt die Permeabilitätszahl viel größer als 1 (zumindest 5, vorzugsweise zumindest 10), sodass das permeable Material allgemein ferromagnetisch oder ferrimagnetisch ist.

In bevorzugter Weiterbildung ist ergänzend zu der magnetischen Lage noch eine elektrische Schirmlage angeordnet. Diese ist (nur) im Bereich der elektrischen Komponente oder (nur) im Bereich der überstehenden Lasche angeordnet. Vorzugsweise erstreckt sie sich jedoch - ebenso wie die magnetische Lage - über die elektrische Komponente und bildet überstehende Laschen aus.

Über die Schirmlage wird insbesondere der Zwischenbereich effektiv abgeschirmt, so dass Störeffekte verringert sind.

Insbesondere ist die elektrische Schirmlage zumindest in Teilbereichen, speziell im Bereich der Laschen als eine Schirmfolie ausgebildet. Vorzugsweise ist die Schirmlage durch eine oder ggf. auch mehrere Schirmfolien gebildet.

In besonders bevorzugter Ausgestaltung bilden die magnetische Lage und die elektrische Schirmlage eine gemeinsame Abschirmfolie aus. Bei dieser handelt es sich daher um eine mehrlagige, insbesondere zweilagige Folie mit der elektrischen Schirmlage, insbesondere aus Kupfer und der magnetischen Lage.

Unter "elektrischer Schirmlage" wird allgemein eine hoch leitfähige Lage verstanden, deren elektrische Leitfähigkeit insbesondere deutlich größer (z.B. um zumindest Faktor 5) ist als die der magnetischen Lage. Umgekehrt ist die Permeabilität der magnetischen Lage vorzugsweise größer, insbesondere deutlich größer (zumindest Faktor 5) als die Permeabilität der elektrischen Schirmlage.

Durch diesen Folienaufbau ist zumindest eine gute Abschirmung und zum anderen eine hohe Sensitivität der Antennenanordnung erreicht. Speziell wird durch diesen Aufbau der Abschirmfolie erreicht, dass in der Abschirmfolie allenfalls geringfügige Wirbelströme hervorgerufen werden und somit lediglich eine sehr geringe Erwärmung erfolgt. Weiterhin verlaufen die Magnetfeldlinien innerhalb der magnetischen Lage.

Insgesamt ist der Zwischenraum - betrachtet man von äußere Felder - quasi feldfrei (H-Feld, E-Feld) und eignet sich besonders für die Anordung von Komponenten. Umgekehrt werden evtl. im Zwischenraum angeordnete Komponenten nach außen abgeschirmt und beeinflussen daher nicht oder kaum die Performance der Antennenvorrichtung.

Ein besonderer Vorteil der Abschirmung des Zwischenraums ist bei einer Ausgestaltung der Antennenvorrichtung für das induktive Laden zu sehen. Bei einem induktivem Laden werden häufig Wirbelströme in einem Gehäuse einer Batterie induziert, was u. A. zu einer unerwünschten Erwärmung der Batterie führt. Durch eine bevorzugte Anordnung der Batterie im Zwischenraum ist diese daher quasi im feldfreien Raum angeordnet, so dass keine Wirbelströme induziert werden.

Die zumindest eine Lasche, speziell auch die mehreren Laschen ist/sind dabei insbesondere durch die mehrlagige Abschirmfolie gebildet oder weisen diese zumindest auf.

Vorzugsweise ist die elektrische Schirmlage in Richtung zu der elektrischen Komponente orientiert und die magnetische Lage in Richtung zu der Wicklung. Die magnetische Lage ist daher - relativ zur elektrischen Schirmlage - weiter außen angeordnet.

In bevorzugter Weiterbildung ist die elektrische Schirmlage dünner als die magnetische Lage. Die magnetische Lage weist vorzugsweise eine Dicke im Bereich von zumindest 25 µm, vorzugsweise von zumindest 50 µm oder von zumindest 100 µm auf. Die Dicke liegt maximal bei beispielsweise 500 µm und vorzugsweise bei maximal 200 oder maximal 300 µm. Speziell liegt in einigen Ausführungsvarianten die Dicke der magnetischen Lage, speziell die Dicke der Ferritfolie, im Bereich zwischen 200 und 300 µm. Durch diese - im Vergleich beispielsweise zu sehr dünnen Lagen im Bereich von 25 µm bis 100 µm - wird eine gute Performance und eine hohe Sensitivität der Antennenanordnung erreicht. Gleichzeitig wird hierdurch die (Biege-)Flexibilität der magnetischen Lage, und damit der gesamten Abschirmfolie reduziert. Bei dünnen magnetischen Lagen mit einer Dicke beispielsweise im Bereich zwischen 25 µm und 100 µm ist dagegen die Biegeflexibilität deutlich höher.

Die Dicke der elektrischen Schirmlage, speziell der Kupferfolie oder Kupferlage, liegt typischerweise im Bereich zwischen 5 µm und 50 µm und vorzugsweise typischerweise im Bereich zwischen 15 bis 35 µm. Für Anwendungen in einem niedrigen Frequenzbereich, z.B. zum induktiven Laden, werden vorzugsweise auch dickere Folien z.b. mit einer Dicke im Bereich zwischen 40 µm bis 80 µm eingesetzt.

In zweckdienlicher Ausbildung steht die elektrische Schirmlage, vorzugsweise an dem den Laschen gegenüberliegenden Ende der Abschirmfolie, in Längsrichtung über die magnetische Lage über. Hierdurch wird im Endbereich der Abschirmfolie eine verbesserte Abschirmung erreicht, sodass der Raumbereich insbesondere innerhalb des Teilabschnitts, in dem die elektrische Komponente angeordnet ist, auch im Endbereich des Teilabschnitts möglichst unbeeinflusst von dem elektromagnetischen Feld der Antennenanordnung ist. Hierdurch sind eventuelle Störfelder, die in den von dem Teilabschnitt umgebenen Raumbereich eindringen, gering gehalten.

In bevorzugter Ausgestaltung sind bei der Abschirmfolie die magnetische Lage und die elektrische Schirmlage deckungsgleich, d.h. sie liegen vollflächig aufeinander. Dies erlaubt eine einfache Herstellung, z.B. indem die gewünschte Form und Geometrie der Abschirmfolie durch einen Stanzprozess erzeugt wird.

Die Gesamtlänge des Teilabschnitts entspricht dabei typischerweise der Länge der elektrischen Komponente. Diese liegt häufig im Bereich beispielsweise zwischen 3 und 7 mm, insbesondere bei etwa 5 mm. Die magnetische Lage ist beispielsweise um einen Bereich von 5% bis 20% der Länge des Teilabschnitts gegenüber der elektrischen Schirmlage in Längsrichtung zurückversetzt.

Die Laschen weisen in einer ersten Variante bevorzugt eine über ihre Länge konstante Breite auf.

In zweckdienlicher Weiterbildung verbreitert sich die elektrische Schirmlage und/ oder die magnetische Schirmlage. Bevorzugt verbreitert sich die elektrische Schirmlage gegenüber der magnetischen Lage. Insbesondere verbreitert sich lediglich die elektrische Schirmlage im Bereich einer jeweiligen Lasche, ausgehend vom Teilabschnitt. Die jeweilige magnetische Lage ist im Bereich einer jeweiligen Lasche vorzugsweise streifenförmig mit bevorzugt konstanter Breite weitergeführt, wohingegen die elektrische Schirmlage sich vergrößert. Durch die sich verbreiternde elektrische Schirmlage wird eine verbesserte Abschirmung des sich aufweitenden Zwischenraums erzielt.

In zweckdienlicher Weise ist die Schirmlage im Bereich der Laschen umfangsseitig geschlossen, insbesondere durchgehend geschlossen, d.h. es liegen keine Spalten oder Freiräume zwischen (in Umfangsrichtung) benachbarten Bereichen der Laschen vor. Vorzugsweise ist die Schirmlage zumindest weitgehend umfangsseitig geschlossen. Hierunter wird verstanden, dass in Umfangsrichtung die Freiräume, in denen keine Schirmlage angeordnet ist, kleiner als 20% oder kleiner als 10% des Umfangs sind. Durch die hohe Flexibilität der elektrischen Schirmlage ist ein Anpassen der Schirmlage an die Innenwandung ohne weiteres möglich. Gleichzeitig ist es für die Sensitivität der Antennenanordnung ausreichend, wenn in den Laschen die magnetische Lage lediglich beispielsweise streifenförmig weitergeführt wird.

Grundsätzlich ist auch eine hohe Überdeckung in Umfangsrichtung mit der magnetischen Lage angestrebt. Allerdings ist ein Überlappen der magnetischen Lage mit der Schirmlage einer benachbarten Lasche zu vermeiden.

In bevorzugter Ausbildung ist die magnetische Lage durch einzelne, voneinander zumindest teilweise und vorzugsweise vollständig getrennte Streifen gebildet, welche sich in Längsrichtung erstrecken. Diese erstrecken sich daher insbesondere über den Teilabschnitt und gehen dann in eine jeweilige, sich an den Teilabschnitt anschließende Lasche über.

Auch die Schirmlage kann durch einzelne Streifen gebildet sind. Es sind beispielsweise mehrere Streifen Abschirmfolie vorgesehen, die jeweils auf eine Seitenfläche der Komponente befestigt, insbesondere geklebt werden.

Die magnetische Lage ist allgemein in bevorzugter Ausgestaltung auf die Schirmlage, speziell auf die Schirmfolie insbesondere durch Kleben aufgebracht. Dies gilt insbesondere in der Ausgestaltung als ein oder mehrere Folien (Ferritfolie) Die einzelnen Streifen sind vorzugsweise jeweils durch eine Folie gebildet.

Sowohl die elektrische Schirmlage als auch die magnetische Lage sind in bevorzugten Varianten durch einen Folienabschnitt und einem weiteren Abschnitt, z.B. einem Festabschnitt mit hoher Eigensteifigkeit ausgebildet.

Gemäß einer ersten Variante ist magnetische Abschirmlage im Bereich der Komponente, also im Teilabschnitt durch eine geeignete Materialwahl des Gehäuses der Komponente gebildet. Das Gehäuse besteht daher aus einem magentischen Material oder ist von einem Gehäusemantel aus dem magnetischen Material umgeben. Bei diesem Material handelt es sich beispielsweise um ein magnetisches (Spritz-) Gussmaterial, speziell ein Spritzguss-Ferrit. Dieses Gussmaterial besteht beispielsweise aus dem magnetischen Material oder es handelt sich um ein Kunststoff-Gussmaterial mit in einer Kunststoff-Matrix eingelagerten magnetischen Partikeln. Die Laschen aus dem magnetischen Material oder auch die mehrlagige Abschirmfolie schließen sich an dieses Gehäuse an, sind beispielsweise an diesem befestigt, insbesondere durch Kleben.

Gemäß einer weiteren Variante, die auch mit der vorhergehenden Variante kombinierbar ist, ist die elektrische Schirmlage im Bereich der Komponente, also im Teilabschnitt durch eine geeignete Materialwahl des Gehäuses der Komponente gebildet. Das Gehäuse besteht daher aus einem Material mit hoher elektrischer Leitfähigkeit oder weist zumindest einen entsprechenden Schirm-Wandungsbereich auf. An diesem Gehäuse ist wiederum die zumindest eine Lasche befestigt.

In zweckdienlicher Ausgestaltung sind in den Zwischenraum weitere Hörgeräte-Komponenten angeordnet. Diese profitieren durch die Abschirmung, sodass die Antennenanordnung und diese Hörgeräte-Komponenten wechselseitig möglichst unbeeinflusst sind. Neben der einen elektrischen Komponente, die von der Wicklung/Spule umwickelt ist, sind in dem abgeschirmten Zwischenraum insbesondere mehrere weiteren Komponenten angeordnet. Hierbei handelt es sich speziell beispielsweise um eine oder mehrere der Komponenten Batterie, integrierte Schaltkreise (beispielsweise ein Hochfrequenz-Schaltkreis, Lade-Schaltkreis), Komponenten einer Signalverarbeitungseinrichtung, wie beispielsweise Verstärker, Filter etc..

Ein entscheidender Vorteil der Abschirmung des Zwischenraums durch die Laschen ist insbesondere auch darin zu sehen, dass gerade für die Anordnung dieser weiteren Hörkomponenten für unterschiedliche Hörgeräte vergleichbare elektromagnetische Bedingungen geschaffen sind, sodass die wechselseitigen Beeinflussungen über unterschiedliche Hörgeräte hinweg zumindest weitgehend identisch sind. Insbesondere bei ITE- oder auch CiC-Hörgeräten werden die Gehäuse häufig als sogenannte customized shells, also individuell angepasste Gehäuseschalen ausgebildet. Hierdurch verändern sich typischerweise die Platzverhältnisse und die Anordnung der einzelnen Komponenten kann sich von Hörgerät zu Hörgerät unterscheiden. Durch die Abschirmung des Zwischenraums und die Anordnung der weiteren Hörgeräte in diesem Zwischenraum ist selbst bei derartigen customized shells über verschiedene Hörgeräte hinweg ein zumindest weitgehend gleiches Performance/Eigenschaftsprofil erreicht und individuelle Anpassungen etc. sind nicht erforderlich oder zumindest reduziert.

In einer bevorzugten Weiterbildung ist eine Leiterplattenfolie vorgesehen, welche die Schirmlage und / oder die magnetische Lage aufweist. Speziell weist die Leiterplattenfolie die Abschirmfolie auf. Unter Leiterplattenfolie wird allgemein ein folienartiger Träger verstanden, welcher aus einem nicht leitenden Kunststoffmaterial besteht und auf dem vorzugsweise Leiterbahnen angebracht sind. Insbesondere ist die elektrische Schirmlage als eine Ebene oder Lage dieser Leiterplattenfolie ausgebildet. Speziell weist die Leiterplattenfolie eine nach Art einer Masseebene ausgebildete leitfähige Lage, insbesondere eine Kupfer-Lage auf. Auf die Leiterplattenfolie ist in bevorzugter Ausgestaltung die magnetische Lage insbesondere durch Kleben aufgebracht.

In bevorzugter Weiterbildung ist an der Leiterplattenfolie eine der weiteren elektrischen Komponenten angeordnet, insbesondere auch elektrisch kontaktiert, beispielsweise über die in die Leiterplattenfolie integrierten Leiterbahnen. Die weitere elektrische Komponente ist dabei bevorzugt in Richtung zu dem Zwischenraum orientiert. Bei diesen Komponenten handelt es sich insbesondere um störende Komponenten. Durch deren Anordnung an der Folie bleiben die Verhältnisse, wie z.B. ein Signal-Rausch-Verhältnis unabhängig von dem speziellen Design des Gehäuse gleich. Dies ist von besonderer Bedeutung bei individuell an den Nutzer angepassten Gehäusen, da sich bei diesen die Geometrie von Hörgerät zu Hörgerät und damit auch die Anordnung und Lage der Komponenten unterscheiden können.

Bei der elektrischen Komponente, welche von dem Teilabschnitt der Abschirmfolie umgeben ist, handelt es sich insbesondere um einen Hörer / Lautsprecher, also um einen elektromagnetischen Wandler. Dieser erzeugt im Betrieb ein sehr starkes elektromagnetisches Feld, welches zur Antennenanordnung hin zuverlässig durch die Abschirmfolie abgeschirmt ist.

In bevorzugter Ausgestaltung sind die Laschen, insbesondere durch die elektrische Abschirmfolie, als Reflexionsflächen für eine HF-Strahlung ausgebildet. Hierunter wird eine Strahlung im Gigahertzbereich, insbesondere im einstelligen Gigahertzbereich, beispielsweise im Bereich von 2,4 GHz verstanden. In einigen Anwendungsbereichen, speziell für sogenannte HF-Anwendungen, erfolgt eine drahtlose Kommunikation oder Datenübertragung in einem solchen Hochfrequenzbereich. Hierbei ist wünschenswert, dass die Strahlung möglichst nicht in Richtung des Kopfes abgegeben wird, da die HF-Strahlung dort stark absorbiert wird. Durch die Ausbildung als HF-Reflexionsfläche, die insbesondere durch die elektrische Schirmlage geschaffen ist, ist gewährleistet, dass eine HF-Welle entweder gerichtet abgestrahlt wird oder verhindert wird, dass diese in den Kopfbereich hineinläuft. Diese durch die Laschen gebildete HF-Reflexionsfläche liegt insbesondere an der Innenwandung des Gehäuses und vorzugsweise vollflächig an.

Bei der elektrischen Komponente handelt es sich typischerweise um eine Komponente, die quaderförmig ausgebildet ist, also im Querschnitt viereckig (ggf. mit abgerundeten Eckkanten) ausgebildet ist. Durch die streifenartige Ausgestaltung der magnetischen Lage wird insbesondere auch erreicht, dass die Abschirmfolie in Bereichen von Eckkanten (die sich in Längsrichtung erstrecken) frei von der magnetischen Lage ist. Da diese dicker, typischerweise deutlich dicker als die elektrische Schirmlage ist, ist zumindest in den Eckbereichen die Dicke der Abschirmfolie insgesamt deutlich reduziert. Hierdurch ist eine bessere Anpassung an das Gehäuse im Bereich der elektrischen Komponente erreicht. Diese ist typischerweise in dem ersten Gehäuseabschnitt angeordnet, welcher in den Gehörkanal beim Tragen eingesteckt ist, sodass also das Gehäuse hier typischerweise eine gerundete, an den Gehörkanal angepasste Querschnittskontur aufweist. Der Innenraum im Bereich des ersten Gehäuseabschnitts wird dabei typischerweise von der elektrischen Komponente (mit der darum angeordneten Antennenanordnung) vollständig ausgefüllt. Der erste Gehäuseabschnitt bildet insofern typischerweise einen an die elektrische Komponente angepassten Kanal aus, in den diese eingesteckt ist.

Alternativ hierzu werden auf jede Seitenfläche der elektrischen Komponente ein Streifen der Abschirmfolie aufgebracht, so dass die Kanten der Komponente jeweils frei von der Abschirmfolie sind.

Der Teilabschnitt ist um den quaderförmigen Körper der elektrischen Komponente herum um damit um die Längsrichtung herum angeordnet. Die gegenüberliegenden Stirnseiten sind dabei vorzugsweise frei gelassen, es wird also lediglich die Mantelfläche der elektrischen Komponente überdeckt. Um den Teilabschnitt der Abschirmfolie ist dann die Wicklung nach Art einer Spule gewickelt. Die Wicklung liegt lediglich im Teilabschnitt vor. Die elektrische Komponente muss dabei umfangsseitig von dem Teilabschnitt der Abschirmfolie nicht zwingend vollständig abgedeckt sein. Ein Trennspalt oder Trennschlitz an gegenüberliegenden Stoßkanten kann ohne wesentliche Beeinträchtigung der Funktionsfähigkeit bestehen. Vorzugsweise ist die elektrische Komponente vollflächig und über den gesamten Umfang von dem Teilabschnitt umgeben.

Die Spule ist vorzugsweise im Ausgangszustand nach Art einer Luftspule ausgebildet, d.h. die einzelnen Wicklungen umgeben einen (Luft-)Freiraum. Eine derartige Spule wird bei der Montage auf die mit der Abschirmfolie versehene elektrische Komponente aufgeschoben. Die Spule, allgemein die Wicklung ist in geeigneter Weise elektrisch kontaktiert und mit einer Sende- und/oder Empfangseinrichtung verbunden.

Ausführungsbeispiele der Erfindung werden nachfolgend anhand der Figuren näher erläutert. Dabei zeigen
- Fig. 1: eine Darstellung eines Gehäuses eines ITE-Hörhilfegerätes mit einer darin einliegenden Antennenanordnung,
- Fig. 2: eine Längsschnittdarstellung durch eine Antennenanordnung mit Hörer,
- Fig. 3: eine Stirnansicht auf eine Antennenanordnung mit Hörer,
- Fig. 4: eine Aufsicht auf eine Abschirmfolie gemäß einer ersten Ausführungsvariante,
- Fig. 5: eine Seitenansicht auf eine um einen Hörer angeordnete Abschirmfolie.

In den Figuren sind gleich wirkende Teile mit den gleichen Bezugszeichen versehen.

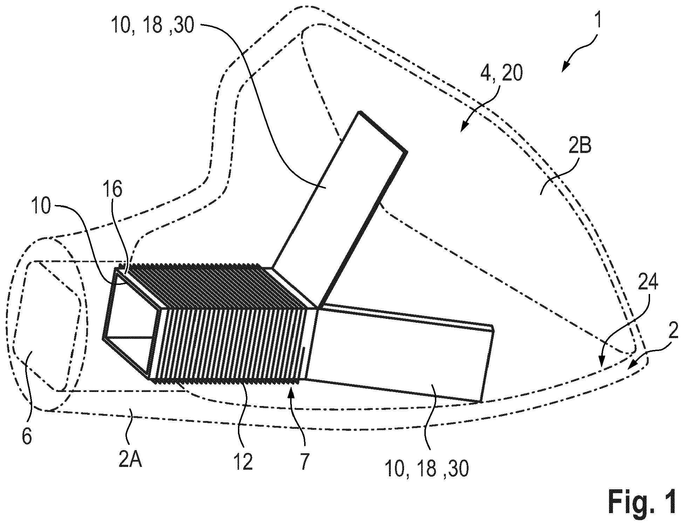

In der Fig. 1 ist ein ITE-Hörhilfegerät 1 teilweise dargestellt. Dieses umfasst ein Gehäuse 2. Das Gehäuse 2 weist dabei einen ersten Gehäuseabschnitt 2A sowie einen sich daran anschließenden zweiten Gehäuseabschnitt 2B auf. Der erste Gehäuseabschnitt 2A erstreckt sich von einem trommelfellseitigen Ende in Richtung zum zweiten Gehäuseabschnitt, welcher an einer trommelfellseitig abgewandten Seite endet. Der erste Gehäuseabschnitt 2A ist zum zumindest teilweisen Einstecken in den Gehörgang einer insbesondere hörgeschädigten Person ausgebildet. Ausgehend vom ersten Gehäuseabschnitt 2A schließt sich der zweite Gehäuseabschnitt 2B an und weitet sich insgesamt auf. Hierdurch ist ein sich aufweitender Innenraum 4 ausgebildet.

Der zweite Gehäuseabschnitt 2B weist endseitig eine vergleichsweise großflächige Öffnung auf. Diese ist typischerweise durch eine sogenannte Faceplate abgeschlossen, also einem Bauteilträger, auf den häufig Anschlüsse, Bedienelemente oder auch Hörkomponenten angeordnet sind. Im Gehäuse 2 sind weitere, hier teilweise nicht weiter dargestellte Komponenten, wie Batterie, Signalverarbeitung, Mikrofone etc. angeordnet.

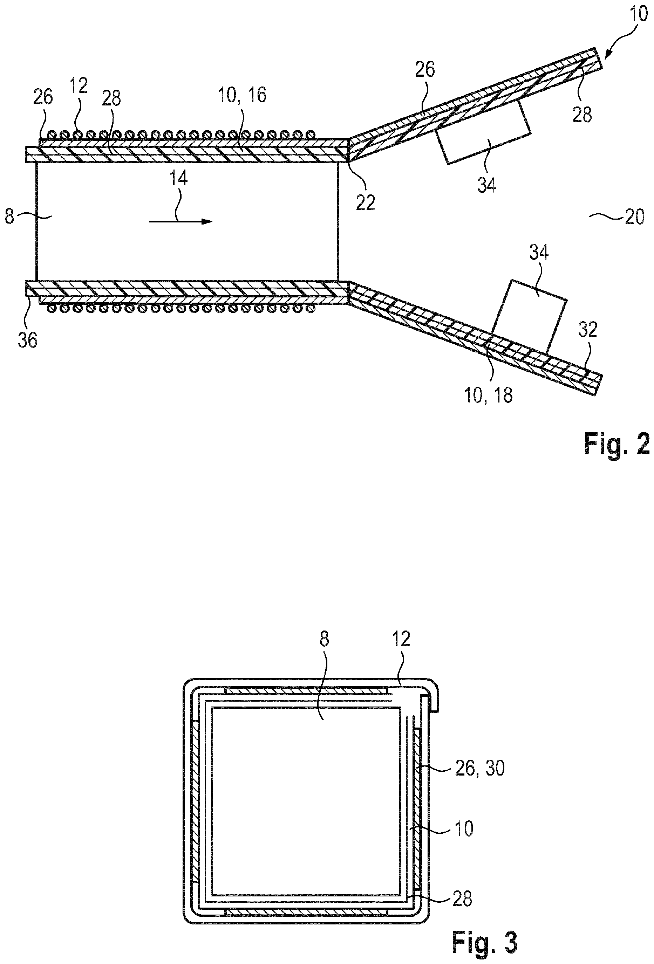

Der erste Gehäuseabschnitt 2A weist trommelfellseitig am Ende einen Schallkanal 6 auf, aus dem Schall in Richtung zum Trommelfell austritt. In dem ersten Gehäuseabschnitt 2A liegt als elektrische Komponente üblicherweise ein Hörer 8 ein, der sich zumindest ein Stück weit in den Schallkanal 6 hinein erstreckt (der Hörer 8 ist in der Fig. 1 nicht dargestellt). Innerhalb des Gehäuses 2 liegt eine Antennenanordnung 7 ein, die als wesentliche Komponenten eine Abschirmfolie 10 sowie eine als Spule ausgebildete Wicklung 12 aufweist. Die Wicklung 12 sowie ein Teil der Abschirmfolie 10 umgibt dabei einen Freiraum, in dem der Hörer 8 einliegt, wie dies insbesondere aus der Darstellung der Fig. 2 zu entnehmen ist. Die Wicklung 12 ist dabei lediglich im Bereich des Hörers 8 angeordnet. Dieser und damit der von der Wicklung 12 umgebene Freiraum erstrecken sich dabei in einer Längsrichtung 14 (Fig. 2), die von der Trommelfellseite des Gehäuses 2 weg orientiert ist.

Die Abschirmfolie 10 weist allgemein einen Teilabschnitt 16 auf, welcher umfangsseitig um den Hörer 8 herum gelegt ist. An diesen Teilabschnitt 16 schließen sich in etwa in Längsrichtung 14 betrachtet einzelne (Schirm-)Laschen 18 an, in denen die Abschirmfolie 10 weiter geführt ist. Bei der typischen Ausgestaltung des Hörers 8 als eine quaderförmige Komponente wird durch eine jeweilige Lasche 18 jeweils eine Quaderseite weiter geführt. Die einzelnen Laschen 18 sind zumindest außerhalb des Teilabschnitts 16 voneinander getrennt. Die Wicklung 12 ist lediglich im Bereich des Teilabschnitts 16 um die Abschirmfolie 10 herum angeordnet.

Anschließend an den Teilabschnitt 16 weiten sich die Laschen 18 auf, sodass also ein zwischen ihnen ausgebildeter Zwischenraum 20 sich - in Längsrichtung 14 betrachtet - aufweitet. Um dies zu ermöglichen, schließen die jeweiligen Laschen 18 zur Längsrichtung einen Knickwinkel ein. Speziell ist am Übergang zwischen einer jeweiligen Lasche 18 zum Teilabschnitt 16 ein Knickgelenk 22 ausgebildet, an dem die jeweilige Lasche 18 jeweils abgeknickt ist. Bei dem Knickgelenk 22 handelt es sich beispielsweise um ein durch eine Materialverjüngung der Abschirmfolie 10 gebildetes Folienscharnier. Ein jeweiliges Knickgelenk 22 ist dabei jeweils senkrecht zur Längsrichtung 14 und parallel zu einer stirnseitigen Kante des Hörers 8 orientiert.

Alternativ zu der Ausgestaltung eines derartigen Knickgelenks 22 weist die Abschirmfolie 10 und insbesondere die Laschen 18 eine ausreichend gute Biegeflexibilität auf, sodass sie aufgrund ihrer Biegeflexibilität ohne weiteres umgebogen werden können.

Insbesondere schmiegen sich die einzelnen Laschen 18 an eine Innenwandung 24 des Gehäuses 2 speziell im Bereich des zweiten, sich aufweitenden Gehäuseabschnitts 2B an. Vorzugsweise sind die Laschen 18 zumindest punktuell oder auch flächig an der Innenwandung befestigt, insbesondere durch Kleben.

Die Abschirmfolie 10 ist mehrlagig ausgebildet und weist zumindest zwei Lagen auf, nämlich eine magnetische Lage 26, welche insbesondere durch eine oder mehrere Ferritfolien gebildet ist, sowie eine elektrische Schirmlage 28, welche insbesondere durch eine elektrisch gut leitfähige Folie oder Lage gebildet ist. Bei dem elektrisch leitfähigen Material handelt es sich insbesondere um Kupfer. Die elektrische Schirmlage ist dabei in Richtung zum Hörer 8 orientiert und die magnetische Lage 26 ist zwischen der elektrischen Schirmlage 28 und der Wicklung 12 angeordnet.

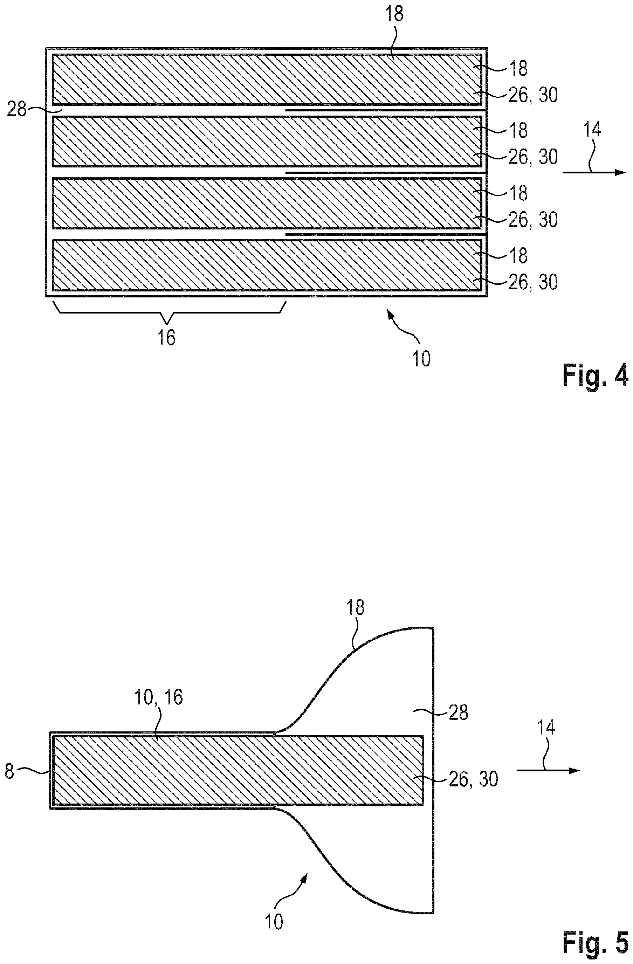

In einer ersten Ausführungsvariante ist die Abschirmfolie 10 gebildet durch die elektrische Schirmlage 28, insbesondere Kupferfolie und der darauf insbesondere durch Kleben angebrachten magnetischen Lage 26. Diese ist beispielsweise vollflächig auf die Schirmlage 28 aufgebracht. Vorzugsweise ist die magnetische Lage 26 jedoch durch einzelne sich in Längsrichtung erstreckende Streifen 30 (vgl. hierzu insbesondere Fig. 4) ausgebildet, die einzelweise auf die elektrische Schirmlage (insbesondere Kupferfolie) 28 aufgebracht sind. Bei diesen einzelnen Streifen 30 handelt es sich dabei jeweils um folienartige Streifen, speziell um Ferrit-Folienstreifen.

Bei der Ausgestaltung der Fig. 2 ist eine Ausführungsvariante der Abschirmfolie 10 dargestellt, bei der diese eine Leiterplattenfolie 32 aufweist. Die elektrische Schirmlage 28 ist in dieser Ausführungsvariante durch eine leitfähige Lage der Leiterplattenfolie 32 ausgebildet. Speziell handelt es sich beispielsweise um eine Zwischenlage, die zwischen zwei isolierenden Kunststoff-Lagen der Leiterplattenfolie 32 ausgebildet ist. Grundsätzlich kann die Schirmlage 28 auch auf eine isolierende Trägerfolie der Leiterplattenfolie 32 einseitig aufgebracht sein. Auf diese Leiterplattenfolie 32 mit der integrierten Schirmlage 28 ist wiederum außenseitig auf die magnetische Lage 26 aufgebracht. Auch hier ist diese vorzugsweise durch einzelne Streifen 30 gebildet.

Die magnetische Lage 26 ist wiederum auf die Leiterplattenfolie 32 beispielsweise durch Kleben aufgebracht. Weiterhin ist in Fig. 2 die außenseitig aufgebrachte Wicklung 10 zu erkennen.

In Längsrichtung 14 anschließend an den Hörer 8 und damit auch an den Teilabschnitt 16 schließen sich die einzelnen Laschen 18 an, von denen in der Querschnittsdarstellung der Fig. 2 zwei gegenüberliegende Laschen 18 zu erkennen sind. Wie in der Fig. 2 dargestellt, sind vorzugsweise unmittelbar an der Leiterplattenfolie 32 weitere elektrische Komponenten 34 angeordnet und beispielsweise auch über die Leiterplattenfolie 32 elektrisch kontaktiert. Hierzu weist die Leiterplattenfolie 32 neben der Schirmlage 28 Leiterbahnen und / oder weitere leitfähige Zwischenlagen auf, über die die Komponenten 34 miteinander elektrisch verbunden werden.

Anhand der Fig. 3 ist nochmals der Aufbau der Antennenanordnung 4 zu entnehmen. Innenliegend ist zunächst der im Querschnitt betrachtet viereckige Hörer 8 angeordnet. Um diesen ist zunächst die elektrische Schirmlage 28 umfangsseitig angeordnet. Diese ist um den Umfang bevorzugt durchgehend ohne Unterbrechungen um den Hörer 8 gewickelt. In einem Stoß- oder Eckbereich kann dabei ein Trennspalt ausgebildet sein, wie dies in der Fig. 3 dargestellt ist.

Weiterhin sind die einzelnen Streifen 30 der magnetischen Lage 26 zu erkennen, die also jeweils auf einer der Quaderseiten angeordnet sind. Um die Abschirmfolie 10 herum ist schließlich die Wicklung 12 angeordnet.

Für die Ausgestaltung der Abschirmfolie 10 sind unterschiedliche Ausführungsvarianten und Geometrien möglich. In der Fig. 4 ist eine bevorzugte Ausgestaltung dargestellt, bei der die Abschirmfolie 10 gebildet ist durch eine beispielsweise rechteckförmige elektrische Schirmlage 28, die in Längsrichtung 12 betrachtet über einen Teilbereich geschlitzt ist. In diesem Teilbereich werden durch die eingebrachten Schlitze die einzelnen Laschen 18 ausgebildet. Der ungeschlitzte Bereich bildet den Teilabschnitt 16 aus. Auf diese Schirmlage 28 sind - für jede Quaderseite genau ein - Streifen 30 aufgebracht. Diese erstrecken sich durchgehend über den Teilabschnitt 16 sowie über die Laschen 18.

In bevorzugter Ausgestaltung steht die elektrische Schirmlage 28 speziell in Richtung entgegen der Längsrichtung 14 in einem Endbereich 36 über die magnetische Lage 26 über. Dies ist insbesondere auch anhand der Fig. 2 zu erkennen. Die Schirmlage 28 steht in Richtung zu der Trommelfellseite und zu der den Laschen 18 abgewandten Seite über die magnetische Lage 26 über. Der Überstand liegt dabei beispielsweise zwischen 3% und 10% der Länge des Teilabschnitts 16 in Längsrichtung 14. Am gegenüberliegenden Ende der Abschirmfolie 10 reicht die magnetische Lage 26 bis zum Ende der Schirmlage 28. Alternativ kann die magnetische Lage 26 etwas zurückversetzt sein. Insgesamt erstreckt sich daher die magnetische Lage 26 zumindest weitgehend über die gesamte Länge der elektrischen Schirmlage 28.

Anhand der Fig. 5 wird eine alternative Ausführungsvariante erläutert. Bei dieser ist vorgesehen, dass die über den Teilabschnitt 16 überstehenden Laschen 18 jeweils eine sich verbreiternde elektrische Schirmlage 28 aufweisen. Beispielsweise verbreitert sich die Schirmlage 28 ausgehend von dem Beginn der Lasche 18 am Teilabschnitt 16 um zumindest 30%, 50%, 100%, 200% oder auch mehr (bezogen auf die Breite am Beginn der Lasche 18 am Teilabschnitt 16). Jede der typischerweise insgesamt vier Laschen 18 ist derart ausgebildet. Vorzugsweise ist die Verbreiterung derart gewählt, dass beim Aufweiten der Laschen 18 und Anschmiegen an die Innenwandung 24 des Gehäuses 2 die Innenwandung 24 in Umfangsrichtung vollständig oder zumindest weitgehend vollständig von der Schirmlage 28 bedeckt ist. Dadurch ist der gesamte Zwischenraum 20 durch die elektrische Schirmlage 28 geschirmt.

Wie insbesondere aus der Fig. 5 zu entnehmen ist, wird ein jeweiliger Streifen 30 der magnetischen Lage 26 unverändert im Bereich der jeweiligen Lasche 18 weitergeführt, d.h. er erfährt keine Verbreiterung. Alternativ ist auch die magnetische Lage 26 verbreiternd ausgebildet.

Die Erfindung wurde vorliegend im Zusammenhang mit einem ITE-Hörhilfegerät 1 näher erläutert. Grundsätzlich lässt sich die hier beschriebene Antennenanordnung 4 auch auf andere Hörhilfegeräte und allgemein auch auf speziell am Kopf tragbare Hörgeräte übertragen Hierunter werden insbesondere auch Headsets, Wearables etc. verstanden. Die vom Teilabschnitt 16 umgebene elektrische Komponente muss dabei nicht zwingend der Hörer 8 sein. Die hier beschriebene Antennenanordnung 7 wird bevorzugt zur Datenübertragung im MHz-Bereich eingesetzt. Darüber hinaus wird sie zusätzlich oder auch alternativ für ein induktives Laden oder auch als Telecoil eingesetzt.

Die Erfindung ist daher nicht auf die hier beschriebenen Ausführungsbeispiele beschränkt. Vielmehr können auch andere Varianten hieraus abgeleitet werden, ohne den durch die Ansprüche definierten

Gegenstand der Erfindung zu verlassen. Insbesondere sind alle im Zusammenhang mit dem Ausführungsbeispiel beschriebenen Einzelmerkmale auch auf andere Weise miteinander kombinierbar, ohne den Gegenstand der Erfindung zu verlassen.

### Bezugszeichenliste

- 1: Hörgerät
- 2: Gehäuse
- 2A, B: erster, zweiter Gehäuseabschnitt
- 4: Innenraum
- 6: Schallkanal
- 7: Antennenanordnung
- 8: Hörer
- 10: Abschirmfolie
- 12: Wicklung
- 14: Längsrichtung
- 16: Teilabschnitt
- 18: Laschen
- 20: Zwischenraum
- 22: Knickgelenk
- 24: Innenwandung
- 26: magnetische Lage
- 28: elektrische Schirmlage
- 30: Streifen
- 32: Leiterplattenfolie
- 34: weitere elektrische Komponente
- 36: Endbereich

## Patentansprüche

1. Hörgerät (1), insbesondere ITE Hörgerät, das aufweist
- ein Gehäuse (2),
- zumindest eine im Gehäuse (2) angeordnete elektrische Komponente (8), insbesondere ein Hörer, die sich in einer Längsrichtung (14) erstreckt,
- eine Antennenanordnung (7), welche eine Wicklung (12) aufweist, die spulenartig um die elektrische Komponente (8) gewickelt ist, wobei zwischen der Wicklung (12) und der elektrischen Komponente (8) eine magnetische Lage (26) angeordnet ist, **dadurch gekennzeichnet, dass** die magnetische Lage (26) einen an der elektrischen Komponente (8) angeordnetenTeilabschnitt (16) sowie zumindest eine sich an diesen Teilabschnitt (16) in Längsrichtung (14) anschließende Lasche (18) aufweist, die in Längsrichtung (14) über die Komponente (8) übersteht, wobei die Lasche (18) einen sich in Längsrichtung (14) an die elektrische Komponente (8) anschließenden Zwischenraum (20) begrenzt.

2. Hörgerät (1) nach dem vorhergehenden Anspruch, **dadurch gekennzeichnet, dass** mehrere Laschen (18) vorgesehen sind, die den Zwischenraum (20) zwischen sich einschließen und der Zwischenraum (20) sich in Längsrichtung (14) betrachtet bevorzugt aufweitet.

3. Hörgerät (1) nach einem der vorhergehenden Ansprüche, wobei das Gehäuse (2) eine Innenwandung (24) aufweist und die zumindest eine Lasche (18) zumindest bereichsweise an dieser anliegt.

4. Hörgerät (1) nach einem der vorhergehenden Ansprüche, wobei die zumindest eine Lasche (18) sich biegeflexibel und vorzugsweise über zumindest ein Knickgelenk (22) an den Teilabschnitt (16) anschließt.

5. Hörgerät (1) nach einem der vorhergehenden Ansprüche, wobei die magnetische Lage (26) eine Folie, insbesondere eine Ferritfolie aufweist.

6. Hörgerät (1) nach einem der vorhergehenden Ansprüche, wobei ergänzend zu der magnetischen Lage (26) eine elektrische Schirmlage (28), insbesondere eine Schirmfolie, im Bereich der elektrischen Komponente (8) und / oder im Bereich der Lasche (18) angeordnet ist.

7. Hörgerät (1) nach dem vorhergehenden Anspruch, wobei die magnetische Lage (26) und die elektrische Schirmlage (28) zumindest in Teilbereichen eine mehrlagige, insbesondere zweilagige Abschirmfolie (10) ausbilden.

8. Hörgerät (1) nach einem der Ansprüche 6 bis 7, wobei die elektrische Schirmlage (28) dünner als die magnetische Lage (26) ist.

9. Hörgerät (1) nach einem der Ansprüche 6 bis 8, wobei die elektrische Schirmlage (28) endseitig, insbesondere an dem den Laschen (18) gegenüberliegenden Ende des Teilabschnitts (16), in Längsrichtung (14) über die magnetische Lage (26) übersteht.

10. Hörgerät (1) nach einem der Ansprüche 6 bis 9, wobei die elektrische Schirmlage (28) und/ oder die magnetische Lage (26) sich im Bereich einer jeweiligen Lasche (18) ausgehend vom Teilabschnitt (16) verbreitert, wobei sich die elektrische Schirmlage (28) insbesondere gegenüber der magnetischen Lage (26) verbreitert.

11. Hörgerät (1) nach einem der Ansprüche 6 bis 10, wobei die elektrische Schirmlage (28) im Bereich der Laschen (18) umfangsseitig zumindest weitgehend oder durchgehend geschlossen ist.

12. Hörgerät (1) nach einem der Ansprüche 6 bis 11, bei dem die magnetische Lage (26) durch einzelne Streifen (30) ausgebildet ist, welche auf die elektrische Schirmlage (28) aufgebracht, insbesondere aufgeklebt sind.

13. Hörgerät (1) nach einem der vorhergehenden Ansprüche, wobei in dem Zwischenraum (20) zumindest eine weitere Komponente (34) angeordnet ist, insbesondere eine oder mehrere der nachfolgenden Komponenten: Batterie, ein oder mehrere integrierte Schaltkreise, Signalverarbeitungseinrichtung, zusätzliche Spulen, wie z.B. Ladespule, Telecoil.

14. Hörgerät (1) nach einem der vorhergehenden Ansprüche und nach Anspruch 6, wobei eine Leiterplattenfolie (32) vorgesehen ist, die die elektrische Schirmlage (28) und insbesondere die Abschirmfolie (10) aufweist, wobei an der Leiterplattenfolie (32) bevorzugt eine weitere elektrische Komponente (34), insbesondere im Zwischenraum (20) angeordnet ist.

15. Hörgerät (1) nach einem der vorhergehenden Ansprüche, wobei die Laschen (18) als Reflexionsflächen für HF-Strahlung ausgebildet sind.

## Claims

1. Hearing aid (1), in particular ITE hearing aid, which has
- a housing (2),
- at least one electrical component (8), in particular a receiver, which is arranged in the housing (2) and extends in a longitudinal direction (14),
- an antenna arrangement (7), which has a winding (12) wound in a coil-like manner around the electrical component (8), a magnetic layer (26) being arranged between the winding (12) and the electrical component (8), **characterized in that** the magnetic layer (26) has a partial section (16) arranged on the electrical component (8) and at least one tab (18), which adjoins said partial section (16) in the longitudinal direction (14) and projects beyond the component (8) in the longitudinal direction (14), the tab (18) delimiting an intermediate space (20), which intermediate space (20) adjoins the electrical component (8) in the longitudinal direction (14).

2. Hearing aid (1) according to the preceding claim, **characterized in that** a plurality of tabs (18) are provided, which enclose the intermediate space (20) therebetween, and the intermediate space (20) preferably widens as viewed in the longitudinal direction (14).

3. Hearing aid (1) according to one of the preceding claims, wherein the housing (2) has an inner wall (24) and the at least one tab (18) rests against it at least in regions.

4. Hearing aid (1) according to one of the preceding claims, wherein the at least one tab (18) adjoins to the partial section (16) in a flexurally flexible manner and preferably via at least one articulated joint (22).

5. Hearing aid (1) according to one of the preceding claims, wherein the magnetic layer (26) has a foil, in particular a ferrite foil.

6. Hearing aid (1) according to one of the preceding claims, wherein in addition to the magnetic layer (26), an electrical shielding layer (28), in particular a shielding foil, is arranged in the region of the electrical component (8) and/or in the region of the tab (18).

7. Hearing aid (1) according to the preceding claim, wherein the magnetic layer (26) and the electrical shielding layer (28) form a multilayer, in particular two-layer, shielding foil (10) at least in partial regions.

8. Hearing aid (1) according to one of claims 6 to 7, wherein the electrical shield layer (28) is thinner than the magnetic layer (26).

9. Hearing aid (1) according to one of claims 6 to 8, wherein the electrical shield layer (28) protrudes in the longitudinal direction (14) beyond the magnetic layer (26) at the end, in particular at the end of the partial section (16) opposite the tabs (18).

10. Hearing aid (1) according to one of claims 6 to 9, wherein the electrical shield layer (28) and/or the magnetic layer (26) widens in the region of a respective tab (18) starting from the partial section (16), wherein the electrical shield layer (28) widens in particular relative to the magnetic layer (26).

11. Hearing aid (1) according to one of claims 6 to 10, wherein the electrical shield layer (28) is at least largely or continuously closed in the region of the tabs (18) on the circumferential side.

12. Hearing aid (1) according to one of claims 6 to 11, in which the magnetic layer (26) is formed by individual strips (30), which are applied, in particular glued, to the electrical shield layer (28).

13. Hearing aid (1) according to one of the preceding claims, wherein at least one further component (34) is arranged in the intermediate space (20), in particular one or more of the following components: battery, one or more integrated circuits, signal processing device, additional coils, such as charging coil, telecoil.

14. Hearing aid (1) according to one of the preceding claims and according to claim 6, wherein a printed circuit board foil (32) is provided, which comprises the electrical shielding layer (28) and in particular the shielding foil (10), wherein a further electrical component (34) is preferably arranged on the printed circuit board foil (32), in particular in the intermediate space (20).

15. Hearing aid (1) according to of the preceding claims, wherein the tabs (18) are designed as reflective surfaces for RF radiation.

## Revendications

1. Aide auditive (1), en particulier aide auditive ITE, comprenant
- un boîtier (2),
- au moins un composant électrique (8) disposé
dans le boîtier (2), en particulier un écouteur, qui s'étend dans une direction longitudinale (14),
- un agencement d'antenne (7), comprenant un enroulement (12), qui est enroulé à la manière d'une bobine autour du composant électrique (8), une couche magnétique (26) étant disposée entre l'enroulement (12) et le composant électrique (8), **caractérisé en ce que** la couche magnétique (26) est disposée dans le boîtier (2), que la couche magnétique (26) comprend une section partielle (16) disposée sur le composant électrique (8) ainsi qu'au moins une patte (18) se raccordant à ladite section partielle (16) dans la direction longitudinale (14), qui dépasse du composant (8) dans la direction longitudinale (14), la patte (18) délimitant un espace intermédiaire (20) se raccordant au composant électrique (8) dans la direction longitudinale (14).

2. Aide auditive (1) selon la revendication précédente, **caractérisée en ce que** plusieurs pattes (18) sont prévues, qui enferment entre elles l'espace intermédiaire (20) et que l'espace intermédiaire (20) s'élargit de préférence, vu dans la direction longitudinale (14).

3. Aide auditive (1) selon l'une des revendications précédentes, dans laquelle le boîtier (2) comprend une paroi intérieure (24) et l'au moins une patte (18) s'appuie au moins par endroits contre celle-ci.

4. Aide auditive (1) selon l'une des revendications précédentes, dans laquelle l'au moins une patte (18) se raccorde à la section partielle (16) de manière flexible en flexion et de préférence par l'intermédiaire d'au moins une articulation articulée (22).

5. Aide auditive (1) selon l'une des revendications précédentes, dans laquelle la couche magnétique (26) comprend une feuille, notamment une feuille de ferrite.

6. Aide auditive (1) selon l'une des revendications précédentes, dans laquelle, en complément de la couche magnétique (26), une couche de blindage électrique (28), en particulier une feuille de blindage, est disposée dans la zone du composant électrique (8) et / ou dans la zone de la languette (18).

7. Aide auditive (1) selon la revendication précédente, dans laquelle la couche magnétique (26) et la couche de blindage électrique (28) forment, au moins dans des zones partielles, une feuille de blindage (10) à plusieurs couches, en particulier à deux couches.

8. Aide auditive (1) selon l'une des revendications 6 à 7, dans laquelle la couche de blindage électrique (28) est plus mince que la couche magnétique (26).

9. Aide auditive (1) selon l'une des revendications 6 à 8, dans laquelle la couche de blindage électrique (28) dépasse de la couche magnétique (26) en direction longitudinale (14), notamment à l'extrémité de la section partielle (16) opposée aux languettes (18).

10. Aide auditive (1) selon l'une des revendications 6 à 9, dans laquelle la couche de blindage électrique (28) et/ou la couche magnétique (26) s'élargit dans la zone d'une patte respective (18) en partant de la section partielle (16), la couche de blindage électrique (28) s'élargissant notamment par rapport à la couche magnétique (26).

11. Aide auditive (1) selon l'une des revendications 6 à 10, dans laquelle la couche de blindage électrique (28) est fermée au moins en grande partie ou de manière continue sur sa périphérie dans la zone des pattes (18).

12. Aide auditive (1) selon l'une des revendications 6 à 11, dans laquelle la couche magnétique (26) est formée par des bandes individuelles (30), qui sont appliquées, notamment collées, sur la couche de blindage électrique (28).

13. Aide auditive (1) selon l'une des revendications précédentes, dans laquelle au moins un autre composant (34) est disposé dans l'espace intermédiaire (20), en particulier un ou plusieurs des composants suivants : batterie, un ou plusieurs circuits intégrés, dispositif de traitement de signal, bobines supplémentaires, telles que bobine de charge, télécoil.

14. Aide auditive (1) selon l'une des revendications précédentes et selon la revendication 6, dans laquelle une feuille de circuit imprimé (32) est prévue, qui comprend la couche de blindage électrique (28) et en particulier la feuille de blindage (10), un autre composant électrique (34) étant de préférence disposé sur la feuille de circuit imprimé (32), en particulier dans l'espace intermédiaire (20).

15. Aide auditive (1) selon l'une des revendications précédentes, dans laquelle les languettes (18) sont conçues comme des surfaces de réflexion pour le rayonnement HF.
